# EUROPEAN PATENT SPECIFICATION

(11) **EP 0 827 216 B1**
(45) Date of publication and mention of the grant of the patent: **24.01.2007**
(21) Application number: 97115009.9
(22) Date of filing: 29.08.1997
(51) Int. Cl.: H01L 37/02

(54) **Improvements in or relating to thermal imaging systems**
Verbesserungen für thermische Bildsysteme
Améliorations de systèmes d'imagerie thermique

(30) Priority: 30.08.1996 US 24926 P
(43) Date of publication of application: 04.03.1998
(73) Proprietor: TEXAS INSTRUMENTS INCORPORATED, Dallas, Texas 75265 (US)
(72) Inventor: Beratan, Howard R., Richardson, TX 75081 (US)
(74) Representative: Degwert, Hartmut

(56) References cited:
- EP-A- 0 454 398
- WO-A-93/09414
- US-A- 4 143 269

## Description

### TECHNICAL FIELD OF THE INVENTION

This invention relates generally to infrared or thermal imaging systems, and more particularly to a thermal detector according to the preamble of claim 1.

### BACKGROUND TO THE INVENTION

Thermal imaging systems are often employed to detect fires, overheating machinery, planes, vehicles and people, and to control temperature sensitive industrial processes. Thermal imaging systems generally operate by detecting the differences in thermal radiance of various objects in a scene and by displaying the differences as a visual image of the scene.

The basic components of a thermal imaging system generally include optics for collecting and focusing thermal radiation from a scene, a thermal detector having a plurality of thermal sensors for converting thermal radiation to an electrical signal, and electronics for amplifying and processing the electrical signal into a visual display or for storage in an appropriate medium. A chopper is often included in a thermal imaging system to A.C. couple the detector to the scene. The chopper produces a constant background radiance which provides a reference signal. The electronic processing portion of the thermal imaging system will subtract the reference signal from the total radiance signal to produce a signal with minimum background bias.

The thermal sensors of a thermal imaging system may be disposed in a focal plans array. The focal plane array and its associated thermal sensors are often coupled to an integrated circuit substrate with a corresponding array of contact pads and a thermal isolation structure disposed between the focal plane array and the integrated circuit substrate. The thermal sensors define the respective picture elements or pixels of the resulting thermal image.

One type of thermal sensor includes a thermal sensitive element formed from pyroelectric material which exhibits a state of electrical polarization and/or change in dielectric constant dependent upon temperature changes of the pyroelectric material in response to incident infrared radiation. A pair of thin film electrodes are generally disposed on opposite sides of the pyroelectric material to act as capacitive plates. In this arrangement, the pyroelectric material acts as a dielectric, or insulator, disposed between the capacitive plates. Accordingly; the electrodes are operable to measure the charge generated by the pyroelectric material in response to changes in temperature. As previously discussed, the charge, or electrical signal, may be amplified and processed into a visual display.

The starting place for fabricating a thermal sensor is typically a wafer of silicon or other suitable material. The wafer may have a diameter of about 150 millimeters (6 inches) and an approximate thickness of 660 microns (26 mils). The materials that form the thermal sensors may be deposited on the wafer in layers and removed as necessary.

EP-A-0 454 398 discloses a thermal sensor with an array of suspended planar detectors with each detector having an organic pyroelectric element between a top nichrome electrode and a bottom gold electrode.

WO-A-93 09414 discloses a thermal sensor with an array of suspended planar detectors with each detector having a stack of a bottom microbridge of silicon dioxide or silicon nitride, a bottom electrode of platinum, an inorganic pyroelectric element made of lead titanate, and a top platinum electrode.

### SUMMARY OF THE INVENTION

A problem with producing thermal sensors having thin film electrodes, however, is that the electrodes often deform during post deposition processing. For example, thin film electrodes are known to develop hillocks or similar deformities along surfaces that abut the pyroelectric layer. The deformities result in electrical leakage through the pyroelectric layer and the thin film electrodes. This leakage degrades the electrical signal and the visual display obtained from the thermal sensor.

Accordingly, a need has arisen in the art for an improved thin film electrode. The present invention provides a thin film electrode that substantially eliminates or reduces the disadvantages and problems associated with prior thin film electrodes.

In accordance with the present invention, the bottom electrode is a solid solution of at least two components which provides increased resistance to the formation of hillocks on the surface of the bottom electrode.

The dielectric element is a thermally sensitive element. The thermally sensitive element is disposed adjacent to the first thin film electrode and the second thin film electrode is disposed adjacent to the thermally sensitive element opposite the first thin film electrode. Additionally, a supporting structure may be provided to support the first thin film electrode in spaced relation with the surface of a substrate. The supporting structure may include at least two posts extending from the surface of the substrate and a pair of bifurcated arms each extending from a electrode and connected to the respective posts.

The thermally sensitive element may comprises a pyroelectric material. The pyroelectric material may be lead lanthanum zirconate titanate. Moreover, the solid solution may include the components of platinum and rhodium. In a particular embodiment, the solid solution may comprise eighty-five (85) percent platinum and fifteen (15) percent rhodium.

Important technical advantages of the present invention include providing an improved thin film electrode. In particular, the bottom electrode comprises a solid solution of at least two components. The solid solution provides increased resistance to the formation of hillocks and other deformities on the surface of the bottom electrode.

Still another important technical advantage of the present invention includes providing an improved electrode assembly having a dielectric element and a pair of thin film electrodes. In particular, the bottom electrode is relatively smooth to reduce electrical leakage through the dielectric element and between the bottom and top electrodes. The reduction in electrical leakage improves the electrical signal obtained from the electrode assembly.

### BRIEF DESCRIPTION OF THE DRAWINGS

For a more complete understanding of the present invention, and the advantages thereof, reference is now made to the following description taken in conjunction with the accompanying drawings, in which:
FIGURE 1 is the block diagram showing the components of one embodiment of a thermal imaging system constructed in accordance with the present invention;
FIGURE 2 is an isometric view of the thermal detector of FIGURE 1, showing a focal plane array mounted to an integrated circuit substrate opposite a thermal element;
FIGURE 3 is a detailed isometric view of the focal plane array of FIGURE 2, showing a matrix of thermal sensor;
FIGURE 4 is a detailed isometric view of one of the thermal sensors of FIGURE 3, showing a thermally sensitive element disposed between a pair of thin film electrodes; and
FIGURES 5A-C are a series of elevation views in section showing various stages of fabrication of the thermal sensor of FIGURE 4 in accordance with one embodiment of the present invention.

### DETAILED DESCRIPTION OF THE INVENTION

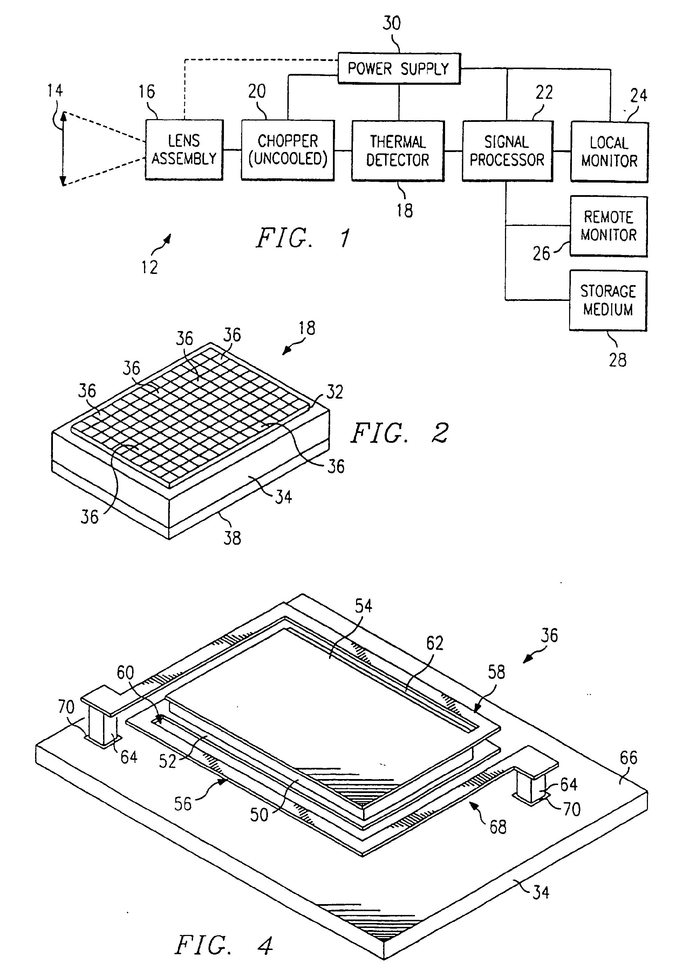

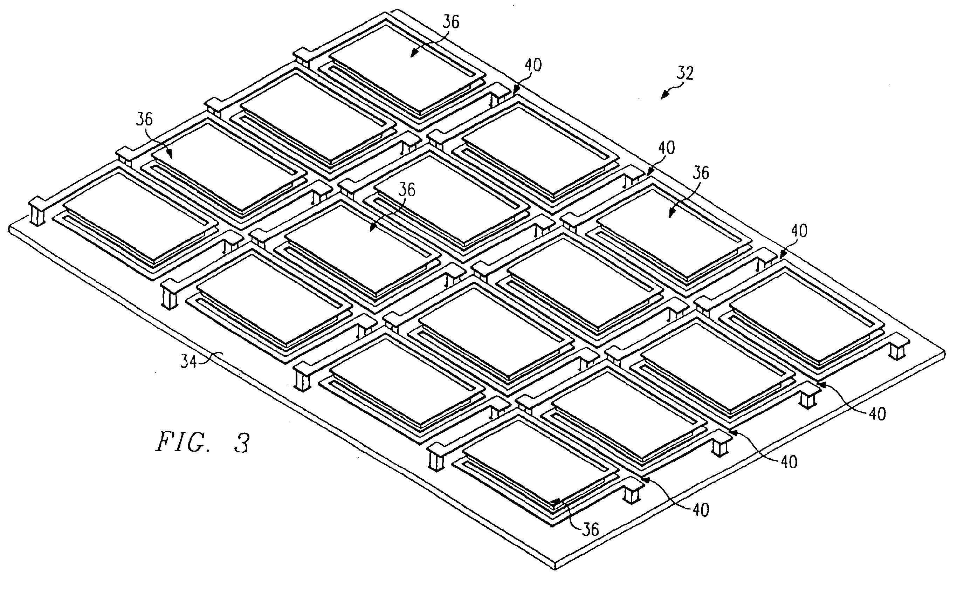

The preferred embodiment of the present invention and its advantages are best understood by referring now in more detail to FIGURES 1-5 of the drawings, in which like numerals refer to like parts throughout the several views. FIGURE 1 shows a schematic block diagram of a thermal imaging system 12 constructed in accordance with the present invention. During operation, the thermal imaging system 12 detects, processes, and displays the heat image of a scene 14.

The thermal imaging system 12 may be especially useful when imaging by means of visual wavelengths is unavailable, such as in the dark or when vision is impaired by smoke, dust, or other particles. In such conditions, the thermal imaging system 12 may detect thermal radiation in the infrared window. The infrared window is a wavelength region in the infrared spectrum where there is good transmission of electromagnectic radiation through the atmosphere. The typically, infrared detectors sense infrared radiation in the spectral bands from 3 to 5 microns (having an energy of 0.4 to 0.25 eV) and from 8 to 14 microns (having an energy of 0.16 to 0.09 eV). The 3-5 micron spectral bend is generally termed the "near infrared band" while the 8 to 14 micron spectral band is termed the "far infrared band." Infrared radiation between the near and far infrared bands cannot normally be detected due to atmospheric absorption of the same. The thermal imaging system 12, however, is also useful during the day and when vision by means of the visual wavelengths is available. For example, the thermal imaging system 12 may be used to detect fires, overheating machinery, planes, vehicles and people, and to control temperature sensitive industrial processes.

As shown in FIGURE 1, the thermal imaging system 12 may comprise a lens assembly 16 in optical communication with a thermal detector 18. The lens assembly 16 focuses or directs thermal radiation emitted by the scene 14 onto the thermal detector 18. The lens assembly 16 may include one or more lenses made of material that transmits thermal radiation, such as germanium. The design of the lens assembly 16 may be varied depending on the particular use of the thermal imaging system 12. For example, the lens assembly 16 may have a constant or a variable F-number and/or may be single field of view or a zoom lens.

The thermal detector 18 may be cooled or uncooled. A cooled thermal detector is operated at cryogenic temperatures such as at the temperature of liquid nitrogen, to obtain the desired sensitivity to variation is infrared radiation. In cases where an uncooled detector 18 is used, a chopper 20 is often disposed between the lens assembly 16 and the thermal detector 18. Preferably, the lens assembly 16, thermal detector 18 and chopper 20 are contained within an associated housing (now shown). The thermal detector 18 may also be contained within a vacuum environment or an environment of low thermal conductivity gas.

The chopper 20 may be controlled by a signal processor 22 to periodically interrupt transmission of the thermal image to the thermal detector 18. Various types of mechanical and/or electrical choppers 20 may be satisfactorily used with the present invention. For example the chopper 20 may be a rotating disk with openings that periodically block and let pass infrared radiation.

The placement of the lens assembly 16 and the chopper 20 with respect to thermal detector 18 is accomplished using well known principles of optical design as applied to thermal imaging systems. As previously described, the lens assembly 16 focuses thermal radiation emitted by the scene 14 onto the thermal detector 18. The thermal detector 18 translates the incoming thermal radiation into corresponding electrical signals for processing.

The electrical signals of the thermal detector 18 may be passed to the signal processor 22, which assembles electrical signals into video signals for display. As previously described, the signal processor 22 may also synchronize operation of the chopper 20. This synchronization enables the signal processor 22 to subtractively process incoming thermal radiation to eliminate fixed background radiation. The output of the signal processor 22 is often a video signal that may be viewed, further processed, stored, or the like.

The video signal of the signal processor 22 may be viewed on a local monitor 24 or fed to a remote monitor 26 for display. The local monitor 24 may be an eye piece containing an electronic viewfinder, a cathode ray tube, or the like. Similarly, the remote monitor 26 may comprise an electronic display, a cathode ray tube, such as a television, or other type of device capable of displaying the video signal. The video signal may also be saved to a storage medium 28 for later recall. The storage medium 28 may be a compact disk, a hard disk drive, random access memory, or any other type of medium capable of storing electronic video signals for later recall. Monitors and storage mediums are well known in the art and therefore will not be further described herein.

Electrical power to operate the thermal imaging system 12 may be provided by a power supply 30. The power supply 30 provides electrical power directly to the chopper 20, the thermal detector 18, the signal processor 22, and to the local monitor 24. Electrical power may also be provided to the lens assembly 16, when, for example, a motor is employed to zoom the lens assembly 16.

FIGURE 2 is a detailed view of the thermal detector 18. The thermal detector 18 may comprise a focal plans array 32 mounted to a substrate 34. In one embodiment, the focal plans array 32 may include a number of thermal sensors 36 arranged in a matrix. The quantity and location of the thermal sensors 36 depend upon the N by M configuration desired for the focal plane array 32.

The configuration of the focal plane array 32 generally varies for different types of thermal detectors 18. In a "staring" thermal detector, for example, the entire thermal image is focused onto a large focal plane array. By contrast, a "scanning" thermal detector uses a mirror or similar means to sweep successive portions of the thermal image across a small focal plane array. Usually, although not necessary for the invention, both types of thermal detectors 18 consist of a number of thermal sensors 36, with the output of each thermal sensor 36 representing a portion of the viewed scene 14. For example, the output of each thermal sensor 36 in focal plane array 32 may represent a single pixel of the total image. This embodiment may be particularly beneficial for use in connection with high density visual displays.

The substrate 34 may be an integrated circuit substrate that provides the necessary electrical couplings and circuitry to process the thermal image formed on the focal plane array 32. The integrated circuit substrate 34 may be formed of silicon, ceramic alumina, or other suitable materials which are both chemically and thermally compatible with the multiple layers which will be formed on the surface 66 (FIGURE 4) of the integrated surface substrate 34. Further information regarding thermal sensors mounted on an underlying integrated circuit substrate is disclosed by U.S. Patent No. 4,143,269 issued to McCormack, et al., entitled "Ferroelectric Imaging System" and U.S. Patent No. 5,021,663 issued to Hornbeck, entitled "Infrared Detector."

A thermal element 38 may be provided to maintain the integrated circuit substrate 34 at a constant predefined temperature. The constant temperature prevents ambient or internally generated temperature gradients from affecting the thermal sensors 36 and thus provides a baseline with which the thermal energy of the scene 14 can be accurately measured. The necessary electrical couplings and circuitry to control the thermal element 38 may be provided by the integrated circuit substrate 34. In such a case, the thermal element 38 may be coupled to the integrated circuit substrate 34 opposite the focal plane array 32.

FIGURE 3 illustrates a detailed view of the previously described focal plane array 32. In this embodiment, the focal plane array 32 includes a matrix of thermal sensors 36. Each thermal sensor 36 forms a discrete element of the focal plane array 32. The thermal sensors 36 may be separated by a set of intersecting slots 40 provided around the perimeter of each thermal sensor 36. The slots 40 provide a high degree of reticulation between adjacent thermal sensors 36 that substantially reduces thermal spreading between the pixel elements.

The thermal sensors 36 may detect thermal radiation using various techniques. For example, the thermal sensors may be based upon the generation of a charge due to a change in temperature resulting from thermal radiation heating the thermal sensors 36. Alternatively, the thermal sensors 36 may be based upon the generation of a charge due to a photon-electron interaction within the material used to form the thermal sensors 36. This letter effect is sometimes called the internal photoelectric effect. The thermal sensors 36 may also be based upon the change in resistance of a thin conductor caused by the heating effect of thermal radiation. Such thermal sensors 36 are sometimes referred to a bolometers. It will be understood that these and other types of thermal sensors 36 may be used in accordance with the present invention.

FIGURE 4 illustrates a detailed view of one of the thermal sensors 36. Each thermal sensor 36 may be an electrode assembly having a dielectric element disposed between a pair of electrically conductive elements. In addition to thermal sensors, the electrode assembly of the present invention may be used for dynamic random access memory (DRAM), nonvolatile memory and the like. For the convenience of the reader, the electrode assembly will be described in the embodiment of the thermal sensor 36. In this embodiment, the dielectric element may be a thermally sensitive element 50. The thermally sensitive element 50 may be disposed between a first electrically conductive element 52 and a second electrically conductive element 54.

In one embodiment, the thermally sensitive element 50 is preferably formed from pyroelectric materials. The pyroelectric materials may also be ferroelectric materials such as barium strontium titanate (BST), barium titanate (BT), and antimony sulfoiodide (SbSI), or any lead containing ferroelectric material including lead titanate (PT), lead lanthanum titanate (PLT), lead zirconate titanate (PZT), lead lanthanum zirconate titanate (PLZT), lead zinc niobate (PZN), lead strontium titanate (PSrT), and lead scandium tantalate (PST). In this embodiment, the thermally sensitive element 50 generates a charge in response to a change in temperature. It will be understood, however, that the present invention contemplates forming the thermally sensitive element 50 from any thermal sensitive material that provides a satisfactory response to thermal radiation.

The thickness of the thermally sensitive element 50 may vary depending upon the wavelength of thermal radiation that the thermal imaging system 12 is designed to detect. The thermally sensitive element 50 is preferably a thin film to enhance responsiveness to thermal radiation and transmission of a generated charge to the electrically conductive elements 52 and 54.

The first electrically conductive element 52 and the second electrically conductive element 54 may be disposed on opposite sides of the thermally sensitive, or pyroelectric, element 50. In this arrangement, the electrically conductive elements 52 and 54 function as electrodes that receive charges generated by the pyroelectric element 50 in response to thermal radiation. Accordingly, the electrodes 52 and 54 are in electrical communication with the pyroelectric element 50, which includes capacitive coupling.

The electrically conductive elements, or electrodes, 52 and 54 may be thin film electrodes. Thin film electrodes 52 and 54 are generally preferred because they may be virtually transparent to thermal radiation. Thin film electrodes are also preferred because they do not rob absorbed thermal energy from the pyroelectric element 50. Additionally, the thin film electrode 52 may be opaque if the infrared radiation is absorbed in a chamber 68 of the thermal sensor 36.

A problem with thin film electrodes, however, is that they often deform during post deposition processing. This is particularly true of the first thin film electrode 52 that may be subjected to high temperatures of between 350 degrees Celsius and 800 degrees Celsius. The high temperatures may cause temperature induced stress during formation of the pyroelectric element 50. As a result, the thin film electrode 52 may develop hillocks or similar deformities along the surface of the thin film electrode 52 that abuts the pyroelectric element 50. The deformities result in electrical leakage through the pyroelectric element 50 and between the thin film electrodes 52 and 54. This leakage degrades the electrical signal and the visual display obtained from the thermal sensor 36.

A significant feature of the present invention is the construction of the first electrode 52 of a solid solution. A solid solution is a solution in a crystalline state where at least one atomic position may accommodate more than one atomic species. A solution is a homogeneous mixture of two or more components. The components of the solid solution preferably should have a high work function and should be compatible with each other and with the pyroelectric element 50. The work function of a component is the energy necessary to free an electron. Typically, a work function of about 4 eV or above is acceptable for the ensemble. Components are compatible where they do not adversely interact with one another or with the pyroelectric element 50.

In one embodiment, as described in detail below, the first electrode 52 may comprise a platinum and rhodium solid solution. It will be understood that other components compatible with one another and with the pyroelectric element 50 and that have an acceptable work function may be used within the scope of the present invention. Other solid solutions may be Ir-Rh with 0-10% Rh, Ir-Ru with 0-40% Ir and 60-100% Rn, Ir-Rd with 0-10% Pd, Pd-Pt with 0-10% Pd and 95 to 100 Pt, Ag-Au with 0-100% of Ap and An, Ag-Pd with 0-100% of Ag and Pd, Ag-In with 0-20 % In, Au-Pt with 0-100% Pt and Ir-Pt with 0-5% Pt. It will be further understood that individual components may have a lower work function provided the work function of the ensemble is acceptable.

The solid solution of the first electrode 52 provides increased resistance to the formation of hillocks and other deformities on the surface of the first electrode 52. Accordingly, the surface of the first electrode 52 remains relatively smooth throughout the process of fabricating the pyroelectric element 50 and other parts of the focal plane array 32. The smooth surface of the first electrode 52 reduces electrical leakage between the pyroelectric element 50 and the first electrode 52. The reduction in leakage improves the electrical signal and visual display obtained from the thermal sensor 36.

The second electrode 54 may also be constructed of a solid solution. Alternately, the second electrode 54 may be formed of various single component materials that are electrically conductive. For example, the second electrode 54 may be formed of palladium or platinum, or from conductive oxides such as ruthenium oxide (Ru0²) or lanthanum strontium cobalt oxide (LSCO).

The thermal sensor 36 is preferably self-supported above the integrated circuit substrate 34. As shown by FIGURE 4, a first support arm 56 preferably extends from the first electrode 52. A second support arm 58 preferably extends from the second electrode 54. In another embodiment, the thermally sensitive element 50 may be divided into separate sections and the support arms 56 and 58 may extend from the same electrode 52 or 54.

For many applications, the support arm 56 is preferably formed from the same type of material as the first electrode 52. Similarly, the support arm 58 is preferably formed from the same type or material as the second electrode 54. The support arms 56 and 58 however may be formed of a different material than the electrodes 52 and 54. Additionally, the thickness of the support arms 56 and 58 may be varied to control thermal conductance between the electrodes and the integrated circuit substrate 34. Thermally sensitive material may be disposed above the support arm 56 and below the support arm 58.

The length, width and thickness of the support arms 56 and 58 may be selected to enhance their resistance to the transfer of thermal energy between the thermal sensor 36 and the integrated circuit substrate 34. In one embodiment, for example, slots 60 and 62 may be formed between each support arm and thus provide additional thermal isolation between the support arms and their associated electrodes. In this embodiment, the thermal isolation of each support arm may increased by lengthening the bifurcated support arm. Thermal isolation may be maximized by fully extending each support arm along opposite halves of the perimeter of the electrodes.

A pair of post 64 may be provided to support the bifurcated arms 56 and 58, and thus the thermal sensor 36, in spaced relation with a surface 66 of the integrated circuit substrate 34. The posts 64 may each support one of the bifurcated support arms. The posts 64 are preferably formed from material which is electrically conductive. In this embodiment, each post 64 may transmit electrical signals from its respective electrode to a contact pad 70 of the integrated circuit substrate 34. Thus, the posts 64 provide both mechanical support and a signal flowpath to the associated contact pad 70.

A chamber 68 may be formed by the gap between the bottom of the first electrode 52 and the surface 66 of the integrated circuit substrate 34. The pyroelectric element 50 may absorb thermal radiation directly or in part after the radiation has passed through the chamber 68 and reflected off the integrated circuit substrate 34. For an embodiment in which thermal radiation is absorbed in part after reflecting off the integrated circuit substrate 34, the dimensions of the chamber 68 may be varied depending upon the wavelength of the thermal radiation that the thermal imaging system 12 is designed to detect. The chamber 68 preferably corresponds to about one-fourth of the selected thermal radiation wavelength. Thus, if thermal imaging system 12 is designed to detect thermal radiation having a wavelength of 7.5 to 14 microns, the chamber 68 preferably has a height of approximately two to three microns. In this embodiment, the electrodes 52 and 54 may be transparent to thermal radiation. The ability to vary the position of bottom of the first electrode 52 with respect to the surface 68 of the integrated substrate 34 enhances the responsiveness of thermal sensor 36 to thermal radiation.

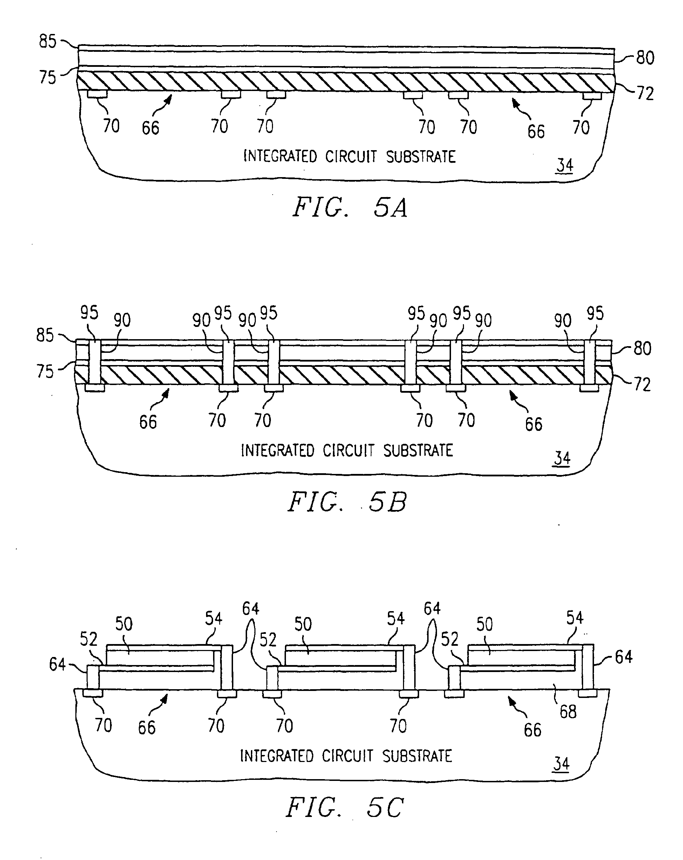

FIGURES 5A-C depict various steps during the process of fabricating the thermal sensors 36 in accordance with an embodiment of the present invention. As shown in FIGURE 5A, an array of contact pads 70 may be disposed on the surface 66 of the integrated circuit substrate 34 to receive electrical signals generated by the thermal sensors 36. As previously described, the integrated circuit substrate 34 may be formed from silicon or other suitable materials which are both chemically and thermally compatible with the multiple layers which will be formed on the surfaces 66 of the integrated surface substrate 34.

A sacrificial layer 72 may be deposited on the integrated circuit substrate 34. During the fabrication process, the sacrificial layer 72 forms a base upon which the thermal sensors 36 may be formed in spaced relation with the integrated circuit substrate 34. Accordingly, the sacrificial layer 72 may be removed after processing to yield the chamber 68.

The sacrificial layer should have a thickness equal to the desired height of the chamber 68. As previously described the height of the chamber preferably corresponds to one-fourth of the selected thermal radiation wavelength. Thus, if thermal sensors 36 are to detect thermal radiation having a wavelength of 7.5 to 14 microns, the sacrificial layer should be deposited in a thickness of approximately two to three microns. The sacrificial layer 72 is preferably silicon dioxide (Si0₂) or polyimide or a similar type of material compatible with fabrication of the thermal sensors 36. A material is compatible with the fabrication of the thermal sensors 36 when it will not inordinately shrink or expand or burn, melt or interact with other material to an extent that it interferes with processing. The material of the sacrificial layer 72 is also preferably removable by way of dry etching techniques.

A first layer of electrically conductive material 75 may next be formed on the sacrificial layer 72. As described below, the first layer of electrically conductive material 75 will form the first electrode 52. In accordance with the invention, the first layer of electrically conductive material 75 is constructed of a solid solution. As previously described, a solid solution is a solution in a crystallized state where at least one atomic position may accommodate more than one atomic species. A solution is a homogeneous mixture of two or more components. The components of the solid solution preferably have a high work function and should be compatible with each other and with other materials of the thermal sensor 36. The work function of a component is the energy necessary to free an electron. Typically, a work function of about 4 eV or above is acceptable for a component.

In one embodiment, the solid solution comprises eighty-five (85) percent platinum and fifteen (15) percent rhodium. The relative amount of platinum may be varied between about ninety-nine (99) percent and about one (1) percent. The relative amount of rhodium may be varied between about one (1) percent and about ninety-nine (99) percent. It will be understood that the solid solution may comprise additional or different components having an acceptable work function and that are compatible with one another and with other materials of the focal plan array 32. Other solid solutions may be Ir-Rh with 0-10% Rh, Ir-Ru with 0-40% Ir and 60-100% Rn, Ir-Pd with 0-10% Pd, Pd-Pt with 0-10% Pd and 95 to 100 Pt, Ag-Au with 0-100% of Ap and An, Ag-Pd with 0-100 % of Ag and Pd, Ag-In with 0-20% In, Au-Pt with 0-100% Pt and Ir-Pt with 0-5% Pt. It will be further understood that individual components may have a lower worked function provided the work function of the ensemble is acceptable.

A layer of thermally sensitive material 80 may next be formed on the first layer of electrically conductive material 75. As described below, the layer of thermally sensitive material 80 will form the thermally sensitive element 50. In one embodiment, the layer of thermally sensitive material 80 is preferably formed from pyroelectric material such as barium strontium titanate (BST), and antimony sulfoiodide (SbSI). In other embodiments, lead containing ferroelectric materials including lead titanate (PT), lead lanthanum titanate (PLT), lead zirconate titanate (PZT), lead lanthanum zirconate titanate (PLZT), lead zinc niobate (PZN), lead strontium titanate (PSrT), and lead scandium tantalate (PST) may be used to form the thermally sensitive layer 80. The selection of material for the thermally sensitive layer 80 depends upon the type of thermal sensor 36 which will be formed on the integrated circuit substrate 34.

A second layer of electrically conductive material 85 may be formed on the thermally sensitive layer 80 opposite from the first layer of electrically conductive material 75. The second layer of electrically conductive material 85 will form the second electrode 54. The second layer of electrically conductive material 85 may be formed of a solid solution or various types of materials such as palladium or platinum. However, the present invention allows other types of electrically conductive material to be used depending on the type of thermal sensor 36 which will be formed on the integrated circuit substrate 34.

Various techniques may be used to form thin film layer 72, 75, 80 and 85. Often these techniques are divided into two groups - film growth by interaction of a vapor deposited species with an associated substrate and film formation by deposition without causing changes to the associated substrate. The first group of thin film growth techniques includes thermal oxidation and nitridation of single crystal silicon and polysilicon. The formation of silicides by direct reaction of deposited metal and the substrate is also frequently included in this first group of thin film growth techniques.

The second group of thin film growth techniques may be further divided into three subclasses of deposition. The first subclass is often referred to as chemical vapor deposition (CVD) in which solid films are formed on a substrate by the chemical reaction of vapor phase chemicals which contain the desired constituents for the associated thin film layer. The second subclass is often referred to as physical vapor deposition (PVD) in which the desired thin film layer is physically dislodged from a source to form a vapor and transport it across a reduced pressure region to the substrate. The dislodged layer is then condensed to form the desired thin film layer. The third subclass typically involves coating the substrate with a liquid which is then dried to form the desired thin film layer. The formation of thin film layers by PVD includes such processes as sputtering, evaporation and molecular beam epitaxy. Spin coating is one of the most commonly used techniques for depositing liquids on a substrate to form a thin film layer.

Thin film layers may also be satisfactorily grown in accordance with the teachings of the present invention by using techniques such as dipping, vapor phase deposition by sputtering or MOCVD, and sol/gel or metal organic decomposition (MOD) by spin coating. Processes should be selected to establish the desired electrical and thermal characteristics for the resulting thermal sensors 36. Additionally, depending upon the type of materials used to form layers 72, 75, 80 and 85, one or more buffer layers or protective layers (not shown) may be disposed between surface 66 of integrated circuit substrate 34 and/or layers 72, 85, 80 and 85.

The various techniques may be integrated to allow fabrication of the thermal sensors 36 on integrated circuit substrate 34 using processes associated with the manufacture of very large scale integrated circuits. Material usage and overall process efficiency associated with fabricating a focal plane array 32 may be substantially improved. For example, thermally sensitive layer 80 is preferably formed with approximately the same thickness as desired for thermal sensitive elements 50. Thus, the possibility of polishing damage associated with previous techniques used to form thermal sensitive elements from pyroelectric materials have been substantially reduced or eliminated.

For applications in which thermally sensitive layer 80 is formed from pyroelectric material such as lead lanthanum zirconate titanate (PLZT), it may be desirable to anneal layer 80 prior to, or following, application of the second layer of electrically conductive material 85. Annealing of layer 80 is generally required to establish the desired pyroelectric characteristics required for the resulting thermal sensors 36. The annealing temperature for lead lanthanum zirconate titanate (PLZT) may be as high as 700C. Thus, an important feature of the present invention includes providing the solid solution of the first layer of electrically conductive material 75 to allow annealing of the thermally sensitive layer 80 with a reduction or absence of hillocks or other deformities formed on the first layer of electrically conductive material 75.

As previously discussed, the solid solution provides increased resistance to the formation of hillocks and other deformities on the surface of the first layer of electrically conductive material 75 during fabrication of the thermally sensitive element 50 and the other parts of focal plan array 32. The smooth surface of the first layer of electrically conductive material 75 reduces electrical leakage from one electrode to the other through the thermally sensitive element 50. The reduction in leakage improves the electrical signal and visual display obtained from the thermal sensors 36.

As best shown by FIGURE 5B, a pair of vias 90 may be formed for each thermal sensor 36. The vias 90 are preferably formed using anisotropic etching or other photolithographic techniques. The post 64 may be formed by filling the vias 90 with a supporting material. For one application, the supporting material 95 may be platinum. However, other types of material may be used for the post 64 depending on the type of thermal sensors 36 that are to be fabricated as well as the temperatures and processes involved in fabrication.

As shown by FIGURE 5C, after forming the desired layers of material 72, 75, 80 and 85 on the surface 66 of the integrated circuit substrate 34 and the posts 64 in the layers, individual thermal sensors 36 may be defined on the integrated circuit substrate 34. As previously discussed, the sacrificial layer 72 is removed during processing to form the cavity 68. Various photolithographic techniques including anisotropic etching processes may be used to define the desired thermal sensors 36. Depending upon the type of materials used to form layers 75, 80 and 85, the anisotropic etching processes may include oxygen-based ion milling, reactive ion etch (RIE) or a magnetically enhanced reactive ion etch (MERIE).

In the resulting thermal sensors 36 the first electrode 52 is preferably formed from the first layer of electrically conductive material 75. The thermally sensitive element 50 is preferably formed from the thermally sensitive element 50 is preferably formed from the thermally sensitive layer 80. The second electrode 54 is preferably formed from the second layer of electrically conductive material 85. The posts 64 are formed from the supporting material 95 in the vias 90. In one embodiment, the post 64 for the bottom electrode 52 may extend past the bottom electrode to the height of the post 64 of the top electrode. The posts 64 rest on he contact pads 70.

Additionally, the thermal sensors 36 preferably include the cavity 68 between the first electrode 52 and the surface 66 of integrated circuit substrate 34. As previously discussed, the cavity 68 will preferably have a height which corresponds to about one quarter of the wavelength of the incident infrared radiation which will be detected by thermal sensors 36. For one application, post 64 and the associated cavity 68 have a height of approximately two and one-half microns.

The sole table below provides an overview of some embodiments in the drawings.

| Drawing Element | Preferred or Specific Term | General Term | Alternative Terms |
|---|---|---|---|
| 16 | Lane Assembly | Optics | |
| 20 | Chopper | Device that interrupts beam of radiation | |
| 22 | Signal Processor | Electronics | |
| 24 | Monitor | Display | Electronics Viewfinder, Cathode ray tube |
| 32 | Focal plane array | Metrix of thermal sensors | |
| 34 | Integrated circuit substrate | Silicon switching matrix | |
| 36 | Pyroelectric sensors | Electrode assembly, thermal sensors | Bolometers |
| 50 | Pyroelectric element | Thermal sensor, dielectric element | Barium strontium titanate (BST), barium titanate (BT), and antimony sulfoiodide (SbSI), or any lead containing ferroelectric material including lead |
| | | | titanate (PT), lead lanthanum titanate (PLT), lead zirconate titanate (PZT), lead lanthanum zirconate titanate (PLZT), lead zinc niobate (PZN), lead strontium titanate (PSrT)), and lead scandium tantalate (PST). |
| 52 | First thin film electrode of platinum and rhodium. | First electrically conductive element of solid solution of two or more components. | |
| 54 | Second thin film electrode | Second electronically conductive element | Solid solution of two or more components, may be platinum and rhodium. |
| 64 | Post | Mechanical support | |

Although the present invention has been described with several embodiments, various changes and modifications may be suggested to one skilled in the art. It is intended that the present invention encompass such changes and modifications as fall within the scope of the appended claims.

## Claims

1. A thermal detector (18) of the type having an array of planar sensors (36) with each sensor (36) including a pyroelectric or ferroelectric element (50), a bottom thin film electrode (52) and a top thin film electrode (54), wherein the bottom and top thin film electrodes (52, 54) are disposed on opposite sides of the pyroelectric or ferroelectric element (50) and are in electrical communication with the pyroelectric or ferroelectric element (50), **characterized in that** the bottom electrode (52) is a solid solution of at least two components which provides increased resistance to the formation of hillocks on the surface of the bottom electrode (52).

2. The detector of claim 1, **characterized by** further comprising a supporting structure to support the bottom thin film electrode in spaced relation with a surface of an integrated circuit substrate(34), the supporting structure comprising:
- at least two posts (64) extending from the surface of the integrated circuit substrate (34); and
- a pair of bifurcated support arms (56, 58) each extending from a thin film electrode (52, 54) and connected to the respective posts (64).

3. The detector of claim 2, **characterized in that** each support arm (56, 58) fully extends along opposite halves of the perimeter of the thin film electrodes (52, 54).

4. The detector of any of claims 1 to 3, **characterized in that** the solid solution consists of components with work functions of at least 4 eV.

5. The detector of any of the claims 1 to 4, **characterized in that** the solid solution is of metals selected from the groups consisting of platinum, rhodium, iridium, ruthenium, and palladium.

## Patentansprüche

1. Wärmedetektor (18) des Typs, der eine Matrix aus ebenen Sensoren (36) besitzt, wobei jeder Sensor (36) ein pyroelektrisches oder ferroelektrisches Element (50), eine untere Dünnschichtelektrode (52) und eine obere Dünnschichtelektrode (54) aufweist, wobei die untere und die obere Dünnschichtelektrode (52, 54) auf gegenüberliegenden Seiten des pyroelektrischen oder ferroelektrischen Elements (50) angeordnet sind und mit dem pyroelektrischen oder ferroelektrischen Element (50) in einer elektrischen Verbindung stehen, **dadurch gekennzeichnet, dass** die untere Elektrode (52) eine feste Lösung aus wenigstens zwei Komponenten ist, die einen erhöhten Widerstand gegenüber der Bildung von Erhebungen auf der Oberfläche der unteren Elektrode (52) schafft.

2. Detektor nach Anspruch 1, **dadurch gekennzeichnet, dass** er ferner eine Tragstruktur umfasst, um die untere Dünnschichtelektrode in einer beabstandeten Beziehung zu einer Oberfläche eines Substrats (34) einer integrierten Schaltung zu tragen, wobei die Tragstruktur umfasst:
- wenigstens zwei Stützen (64), die sich von der Oberfläche des Substrats (34) der integrierten Schaltung erstrecken; und
- ein Paar gabelförmiger Tragarme (56, 58), wovon sich jeder von einer Dünnschichtelektrode (52, 54) erstreckt und mit den entsprechenden Stützen (64) verbunden ist.

3. Detektor nach Anspruch 2, **dadurch gekennzeichnet, dass** sich jeder Tragarm (56, 58) vollständig längs gegenüberliegender Hälften des Umfangs der Dünnschichtelektroden (52, 54) erstreckt.

4. Detektor nach einem der Ansprüche 1 bis 3, **dadurch gekennzeichnet, dass** die feste Lösung aus Komponenten mit einer Austrittsarbeiten von wenigstens 4 eV besteht.

5. Detektor nach einem der Ansprüche 1 bis 4, **dadurch gekennzeichnet, dass** die feste Lösung eine aus Metallen ist, die aus den Gruppen ausgewählt sind, die aus Platin, Rhodium, Iridium, Ruthenium und Palladium bestehen.

## Revendications

1. Détecteur thermique (18) du type comportant un réseau de capteurs planaires (36), dont chaque capteur (36) comprend un élément pyroélectrique ou ferroélectrique (50), une électrode inférieure à couche mince (52) et une électrode supérieure à couche mince (54), dans lequel les électrodes inférieure et supérieure à couche mince (52, 54) sont disposées sur les côtés opposés à l'élément pyroélectrique ou ferroélectrique (50), et sont en communication électrique avec l'élément pyroélectrique ou ferroélectrique (50), **caractérisé en ce que** l'électrode inférieure (52) est une solution solide, d'au moins deux composants, qui fournit une résistance accrue à la formation de bosses sur la surface de l'électrode inférieure (52).

2. Détecteur selon la revendication 1, **caractérisé en ce qu'**il comprend, en outre, une structure de support pour soutenir l'électrode inférieure à couche mince en relation espacée avec une surface d'un substrat de circuit intégré (34), la structure de support comprenant :
- au moins deux montants (64) s'étendant depuis la surface du substrat de circuit intégré (34) ; et
- une paire de bras de support bifurqués (56, 58), chacun s'étendant depuis une électrode à couche mince (52, 54), et étant raccordé aux montants respectifs (64).

3. Détecteur selon la revendication 2, **caractérisé en ce que** chaque bras de support (56, 58) s'étend entièrement le long des moitiés opposées du périmètre des électrodes à couche mince (52, 54).

4. Détecteur selon l'une quelconque des revendications 1 à 3, **caractérisé en ce que** la solution solide est constituée de composants présentant des valeurs de travail d'extraction d'au moins 4 eV.

5. Détecteur selon l'une quelconque des revendications 1 à 4, **caractérisé en ce que** la solution solide est de métaux sélectionnés parmi les groupes comprenant du platine, du rhodium, de l'iridium, du ruthénium et du palladium.
